(19) Europäisches Patentamt
European Patent Office
Office européen des brevets

(11) Veröffentlichungsnummer : **0 027 233**
**B1**

(12) # EUROPÄISCHE PATENTSCHRIFT

(45) Veröffentlichungstag der Patentschrift : **24.08.83**

(51) Int. Cl.$^3$ : **H 04 B 12/04**, H 04 B 1/66

(21) Anmeldenummer : **80106050.0**

(22) Anmeldetag : **06.10.80**

(54) **Verfahren zur Codierung von Analogsignalen.**

(30) Priorität : **12.10.79 DE 2941452**

(43) Veröffentlichungstag der Anmeldung : **22.04.81 Patentblatt 81/16**

(45) Bekanntmachung des Hinweises auf die Patenterteilung : **24.08.83 Patentblatt 83/34**

(84) Benannte Vertragsstaaten : **AT BE CH FR GB IT LI LU NL SE**

(56) Entgegenhaltungen :
**DE A 2 124 754**
**FR A 2 314 618**
**US A 3 422 227**
**US A 3 813 601**

**NACHRICHTENTECHNISCHE ZEITSCHRIFT, Band 25, Nr. 4, April 1972, Seiten 179-186 Berlin, DE. R. LIPPMANN et al. : « Nachrichten Reduktion für Raumfahrtexperimente »**

**PROCEEDINGS OF THE IEEE, Band 55, Nr. 10, Oktober 1967, Seiten 1707-1717 New York, U.S.A. G.P. RICHARDS et al. : « Redundancy reduction applied to coarse-fine encoded video »**

(73) Patentinhaber : **POLYGRAM GmbH**
**Harvestehuder Weg 1-4**
**D-2000 Hamburg 13 (DE)**

(72) Erfinder : **Blüthgen Björn**
**Gudehusweg 4**
**D-3100 Celle (DE)**

(74) Vertreter : **Mehl, Ernst, Dipl.-Ing.**
**Postfach 22 01 76**
**D-8000 München 22 (DE)**

**EP 0 027 233 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

# Verfahren zur Codierung von Analogsignalen

Die Erfindung bezieht sich auf ein Verfahren zur Codierung von Analogsignalen für Speicher- bzw. Übertragungszwecke, bei dem die abgetasteten Augenblickswerte der Analogsignale in einem Codierer in PCM-Codeworte umgesetzt und anschließend aus jeweils zwei aufeinanderfolgenden PCM-Codeworten durch Differenzbildung PCM-Differenzcodeworte gebildet werden, bei dem ferner jedes der eine Impulsgruppe darstellenden PCM-Differenzcodeworte zusammen mit wenigstens einem weiteren Hilfscodeelement ein Codewort mit fest vorgegebener Länge (Referenzcodewort) bildet, das zur Reduktion des digitalen Signalflusses unter Berücksichtigung der Hilfscodeelemente kürzer gewählt ist als die maximal mögliche Länge eines PCM-Differenzcodewortes, und bei dem bei Auftreten eines eine Überlänge aufweisenden PCM-Differenzcodewortes dieses durch ein Sondercodewort der im Datenformat vorgegebenen Länge ersetzt wird.

Wie die Betrachtung der Qualitätsparameter für die Speicherung oder Übertragung codierter Analogsignale zeigt, ergeben sich bei der gleichförmig quantisierten Pulscodemodulation, bezogen auf das Nutzsignal, besonders günstige Verhältnisse. Zur Reduzierung der Elementezahl der Codeworte kann von der sogenannten Differenz-Pulscodemodulation Gebrauch gemacht werden, bei der lediglich die Amplitudenänderungen aufeinanderfolgender Augenblickswerte des Analogsignals in digital codierter Form gespeichert bzw. übertragen werden. Bei gegebenen Qualitätsanforderungen ist dabei die pro Differenz-PCM-Codewort anfallende Codeelementmenge durch die maximal mögliche Änderung der Amplitude zwischen zwei aufeinanderfolgenden Augenblickswerten des Analogsignals gegeben. Grundsätzlich besteht zwar die Möglichkeit, die Übertragungs- bzw. Speicherkapazität dadurch herabzusetzen, daß die Codeelementmenge eines Codewortes nur so groß gewählt wird, wie sie jeweils für die Darstellung der Größe des Momentanwertes erforderlich ist. Dies erfordert jedoch in jedem Codewort zusätzliche Codeelemente. Bei unterschiedlicher Wortlänge können diese durch Bitfehler verloren gehen, was bei der Rückgewinnung des ursprünglichen Analogsignals Störungen verursacht. Üblicherweise verwenden PCM-Redundanzreduktionsverfahren deshalb für die Übertragung der Augenblickssignalwerte jeweils eine konstante Codeelementmenge, die gegenüber einem bei gleichförmiger Quantisierung vorhandenen Maximalwert reduziert ist. Dabei werden die binär codierten Momentanwerte, einzeln oder blockweise, durch entsprechende zusätzliche Codeelemente gekennzeichnet, kompandiert übertragen. Die Beeinträchtigung der Qualität des zurückgewonnenen ursprünglichen Analogsignals ist in diesem Falle unerwünschterweise vom Kompandierungsgrad abhängig.

Die Hauptaufgabe, die der Erfindung zugrunde liegt, besteht darin, für die Übertragung bzw. Speicherung digital codierter Analogsignale eine weitere Lösung aufzuzeigen, die die Qualität einer gleichförmig quantisierten PCM auch bei reduzierter konstanter Codeelementmenge pro Codewort in bezug auf jeden Augenblickswert voll bzw. optimal gewährleistet.

Eine weitere Aufgabe der Erfindung besteht darin, unter Anwendung reduzierter konstanter Codeelementmengen eine einfache Lösung zur frequenzselektiven Begrenzung bei der Aufbereitung von Analogsignalen zur Speicherung oder zur Übertragung durch Medien anzugeben.

Ausgehend von einem Verfahren zur Codierung von Analogsignalen für Speicher- bzw. Übertragungszwecke der einleitend genannten Art wird die Hauptaufgabe gemäß der Erfindung durch die im Kennzeichen des Anspruchs 1 angegebenen Merkmale gelöst.

Durch die Literaturstelle « Nachrichtentechnische Zeitschrift », NTZ, 1972, Heft 4, Seiten 179 bis 186, ist es zwar an sich bekannt, zur Redundanzreduktion bei der Übertragung von Daten in digitaler Form von der Differenzpulscodemodulation in der Weise Gebrauch zu machen, daß in der Folge von Differenzcodeworten in vorgegebenen Abständen sogenannte Stützwerte auftreten, die hierbei PCM-Worte sind. Dabei ist die Länge der Differenzcodeworte kleiner gewählt als dies ihrem möglichen Maximalwert entspricht. Tritt ein überlanges Differenzcodewort auf, dann wird es durch ein Sondercodewort der im Datenformat vorgegebenen Länge ersetzt. Dieses Sondercodewort stellt dabei eine Art Füllwort dar. Bei der redundanzreduzierten digitalen Übertragung von analogen Signalen würden solche Sondercodeworte im Informationsfluß eine erhebliche Störung darstellen. Durch die erfindungsgemäße Gestaltung dieses Sondercodewortes läßt sich in außerordentlich vorteilhafter Weise eine redundanzreduzierte Übertragung bzw. Speicherung digital codierter Analogsignale verwirklichen, bei der die Qualität pro Codewort in bezug auf jeden Augenblickswert voll bzw. optimal gewährleistet wird.

Auch ist durch die Literaturstelle « Proceedings of the IEEE », Vol. 55, Nr. 10, Oktober 1967, Seiten 1707 bis 1717, eine Videoübertragungseinrichtung bekannt, bei der die digitalen Signale ebenfalls in redundanzreduzierter Form übertragen werden. Bei diesem speziellen Verfahren werden von den jeweils 6 Bit aufweisenden Codeworten entweder nur 3 Bits der höchsten Wertigkeit oder nur 3 Bits der niedrigsten Wertigkeit übertragen je nachdem ob die Bildinformation sich schnell ändert oder nicht. Beim Erfindungsgegenstand wird im Gegensatz hierzu von einer sogenannten Kompandierung Gebrauch gemacht, bei der die Bits höchster Wertigkeit immer übertragen werden und nur dann, wenn das Codewort eine Überlänge anzeigt, die erforderliche Kürzung auf die Länge des Referenzcodewortes durch Weglassen der niedrigstwertigsten Bits vorgenommen wird.

Bei dem durch die FR-A-2 314 618 bekannten Videoübertragungsverfahren wird zur Redundanzreduktion der Signale ebenfalls von einer Differenzpulscodemodulation Gebrauch gemacht und darüber hinaus dann diese Differenzpulscodewortfolge in einen Spezialcode umgewandelt, der es ermöglicht, aufeinanderfolgende übereinstimmende Abtastwerte nur einmal zu übertragen. Beim Erfindungsgegenstand wird von einer solchen Übertragung kein Gebrauch gemacht, sondern lediglich den eigentlichen Informationsbits wenigstens ein Hilfsinformationsbit beigefügt.

Der Erfindung liegt die Erkenntnis zugrunde, daß die für eine vorgegebene Codeelementmenge bei Anwendung einer Reduktion des digitalen Signalflusses notwendige zusätzliche Momentanwertumcodierung auf die bei Analogsignalen, wie Sprache und Musik, nur unregelmäßig verteilt auftretenden großen Amplitudenänderungen zwischen aufeinanderfolgenden Augenblickswerten beschränkt ist. Mit anderen Worten werden dadurch die meisten zu übertragenden digital codierten Momentanwerte von der Umcodierung nicht erfaßt und können damit hierdurch auch keine Qualitätsminderung erfahren. Die Qualitätsminderung des zurückgewonnenen ursprünglichen Analogsignals durch die Redundanzreduktion großer Amplitudendifferenz zwischen aufeinanderfolgenden Augenblickwerten ist ihrerseits durch die unregelmäßige zeitliche Verteilung und ihr nur gelegentliches Auftreten praktisch vernachlässigbar.

Das relativ seltene Auftreten großer Momentanwertdifferenzen auch dann, wenn das Referenzcodewort erheblich kürzer gewählt ist als die maximal mögliche Länge eines PCM-Differenzcodewortes, hat seinen Grund darin, daß der maximal mögliche Wert der Amplitudendifferenz zwischen zwei aufeinanderfolgenden Augenblickswerten des Analogsignals infolge der festen Abtastperiode frequenzabhängig ist; mit anderen Worten nimmt dieser Maximalwert umgekehrt proportional zur Signalfrequenz ab. Die erfindungsgemäße Reduktion erfolgt deshalb nur dort, wo bezogen auf ein Analogsignal konstanter Amplitude und Frequenz der Quotient aus der Abtastfrequenz und der Nutzsignalfrequenz nicht kleiner ist, als das Amplitudenverhältnis aus der Amplitudendifferenz zweier aufeinanderfolgender Augenblickswerte des Analogsignals und dem bei vorgegebener Stufung der Quantisierung durch die vorgegebene Codeelementmenge in einem Codewort darstellbaren maximalen Amplitudenwert ist. Für alle Signale unterhalb dieses Grenzwertes entspricht die Qualität des zurückgewonnenen ursprünglichen Analogsignals derjenigen eines nicht reduzierten codierten Signals (PCM).

Ein besonders hoher Qualitätsstandard wird in vorteilhafter Weise dann erreicht, wenn der Erzeugung der PCM-Codeworte und der hieraus abgeleiteten PCM-Differenzcodeworte eine gleichmäßige Quantisierung zugrunde gelegt wird.

Bei einer ersten vorteilhaften Methode zum Ersatz eines überlangen PCM-Differenzcodewortes durch das für die Gewinnung dieses PCM-Differenzcodewortes zuletzt erzeugte PCM-Codewort wird dieses durch Weglassen einer entsprechenden Anzahl der jeweils niedrigstwertigen Codeelemente auf die vom Referenzcodewort vorgegebene übertragbare Länge gekürzt (Kompandierung).

Besonders zweckmäßig ist es weiterhin, daß bei Ersatz eines oder mehrerer überlanger PCM-Differenzcodeworte durch kompandierte PCM-Codeworte bei nachfolgenden Übergang auf PCM-Differenzcodeworte das erste PCM-Differenzcodewort aus der Differenz des letzten kompandierten PCM-Codewortes mit dem zeitlich unmittelbar folgenden PCM-Codewort gebildet wird. Auf diese Weise lassen sich unvermeidbare Nutzsignalrestverzerrungen wesentlich verringern.

Bei einer vorteilhaften zweiten Methode, bei der ein überlanges PCM-Differenzcodewort durch das für die Gewinnung dieses PCM-Differenzcodewortes zuletzt erzeugte PCM-Wort erfolgt, wird dieses bei gleichzeitiger Anwendung einer Zwischenspeicherung auf zwei aufeinanderfolgende Codeworte aufgeteilt. Auf diese Weise wird die Rekonstruktion des ursprünglichen Analogsignals auch dann mit hoher Sicherheit gewährleistet, wenn das in die digitale Ebene umgesetzte Signal Störungen in Form von Bit- oder auch Codewortverlusten erleidet, und zwar deshalb, weil jedes dieser ein überlanges PCM-Differenzcodewort ersetzenden PCM-Worte bei der Rückumwandlung als Referenzwert dienen kann. Sind dagegen solche Referenzwerte nicht vorhanden, dann führt der Verlust von einzelnen Codeelementen oder gar ganzer Codewörter des in die digitale Ebene umgesetzten Analogsignals bei der Rückumwandlung zu einer erheblichen Beeinträchtigung der Signalqualität, weil sich ja jedes der PCM-Differenzcodeworte auf das vorhergehende PCM-Differenzcodewort bezieht.

Bei einer dritten vorteilhaften Methode beinhaltet das das überlange PCM-Differenzcodewort ersetzende Codewort den größten Augenblicksamplitudendifferenzwert, der durch die ihm vorgegebene Codeelementzahl im verwendeten Code darstellbar ist, und zwar unter Berücksichtigung der Polarität des zu ersetzenden überlangen PCM-Differenzcodewortes.

In Weiterbildung der Erfindung läßt sich diese dritte Methode zur Lösung der genannten weiteren Aufgabe zur frequenzselektiven Amplitudenbegrenzung eines analogen Signals in Abhängigkeit der Amplitudenanstiegsgeschwindigkeit dadurch verwenden, daß die in ihrer Länge vom Referenzcodewort bestimmten Codeworte einem Codewandler zur Rückgewinnung der PCM-Codeworte zugeführt werden, aus denen dann anschließend in einem Decodierer das ursprüngliche Analogsignal in begrenzter Form erhalten wird.

Anhand von in der Zeichnung dargestellten Ausführungsbeispielen soll die Erfindung im folgenden noch näher erläutert werden. In der Zeichnung bedeuten

Figur 1 die schematische Darstellung eines PCM-Codewortes mit gleichförmiger Quantisierung,

Figur 2 die schematische Darstellung eines PCM-Differenzcodewortes mit gleichförmiger Quantisierung,

Figur 3 die schematische Darstellung eines PCM-Differenzcodewortes mit Kompandierung,

Figur 4 die schematische Darstellung eines PCM-Codewortes mit Kompandierung,

Figur 5 die schematische Darstellung eines PCM-Doppelcodewortes mit gleichförmiger Quantisierung,

Figur 6 die schematische Darstellung eines PCM-Differenzcodewortes bei Anwendung einer Begrenzung auf den Maximalwert bei auftretender Überlänge,

Figur 7 die Zeitmatrix einer PCM-Codewortfolge entsprechend Fig. 1,

Figur 8 die Zeitmatrix der in PCM-Differenzcodeworte umgesetzten PCM-Codewortfolge nach Fig. 7,

Figur 9 die Zeitmatrix der PCM-Differenzcodewortfolge nach Fig. 8 mit Kompandierung überlanger PCM-Differenzcodeworte,

Figur 10 die Zeitmatrix der PCM-Differenzcodeworte nach Fig. 8 mit einem Ersatz überlanger PCM-Differenzcodeworte durch kompandierte PCM-Codeworte,

Figur 11 die Zeitmatrix der PCM-Differenzcodewortfolge nach Fig. 8 bei Ersatz der überlangen PCM-Differenzcodeworte durch PCM-Doppelcodeworte,

Figur 12 die Zeitmatrix der PCM-Differenzcodeworte nach Fig. 8 mit einem Ersatz überlanger PCM-Differenzcodeworte durch PCM-Differenzcodeworte maximalen Wertes,

Figur 13 das Blockschaltbild einer Sende-Empfangsanordnung zur Übertragung von PCM-Differenzcodeworten mit einer Kompandierung überlanger PCM-Differenzcodeworte,

Figur 14 das Blockschaltbild einer Sende-Empfangsanordnung für die Übertragung von PCM-Differenzcodeworten, bei der überlange PCM-Differenzcodeworte durch kompandierte PCM-Codeworte oder PCM-Doppelcodeworte ersetzt sind,

Figur 15 das Blockschaltbild einer Schaltungsanordnung zur frequenzselektiven Begrenzung der Amplitude eines Analogsignals in Abhängigkeit der Amplitudenänderungsgeschwindigkeit,

Figur 16 ein die Wirkungsweise der Begrenzerschaltung nach Fig. 15 erläuterndes Diagramm.

Bei dem in Fig. 1 dargestellten Codeschema PCM bedeutet x die Wortgröße des PCM-Codewortes. Die Wortgröße x der Codeelementmenge Qx umfaßt die Codelemente 1 bis 16. Weiterhin enthält das Codeschema PCM einen Pfeil, der die Richtung der Wertigkeit der Codeelemente vom niedrigstwertigen Codeelement LSB zum höchstwertigen Codeelement MSB angibt. Die Wortgröße x entspricht hier der Größe des Referenzcodewortes RC, die jedes der einen Abtastwert eines Analogsignals darstellenden PCM-Codeworte in der Signalflußkette hat.

Bei der Differenzbildung zweier aufeinanderfolgender PCM-Codeworte zu einem PCM-Differenzcodewort kommt das in Fig. 2 dargestellte Codeschema PCM-D zustande. Das Referenzcodewort RC setzt sich hier aus der Wortgröbe y mit der Codeelementmenge Qy der Codeelemente 1 bis 9 und zwei Hilfscodeelementen zusammen, von denen das eine ein die Polarität P anzeigendes Codeelement ist und das andere Hilfscodeelement C die Art der Codierung markiert.

Übersteigt die Wortgröße y nach Fig. 2 die Zahl von neuen Codeelementen, dann ist ein solcher Momentanwert nicht mehr bei der vorgegebenen Länge des Referenzcodewortes RC übertragbar. In diesem Fall muß für die Übertragung eine Kompandierung vorgesehen werden. Im Codeschema PCM-D K der Fig. 3 ist dies dargestellt. Die Wortgröße y' beinhaltet auch hier eine Codeelementmenge Qy' von neuen Elementen, doch werden lediglich die Codeelemente 3 bis 11 übertragen, während die niedrigstwertigen Codeelemente 1 und 2 der Kompandierung zum Opfer gefallen sind.

Anstatt einer Kompandierung des überlangen PCM-Differenzcodewortes besteht auch die Möglichkeit, anstelle dieses überlangen PCM-Differenzcodewortes das für seine Gewinnung zuletzt erzeugte PCM-Codewort heranzuziehen. Das Codeschema PCM K nach Fig. 4 zeigt ein solches kompandiertes PCM-Codewort, bei dem die Wortgröße z bei der Codeelementmenge Qz lediglich die zehn höchstwertigen Codeelemente 7 bis 16 entsprechend Fig. 1 aufweist. Das übrige der insgesamt elf Codeelemente aufweisenden Codeelementmenge Qz wird wiederum von dem die Codeart markierenden Hilfscodeelement C gebildet.

Das Codeschema PCM 2 C nach Fig. 5 zeigt schließlich den Fall, bei dem das anstelle des überlangen PCM-Differenzcodewortes verwendete PCM-Wort in zwei aufeinanderfolgenden Codeworten mit der Wortgröße x/2 übertragen wird. Im ersten Codewort des Doppelwortes wird die Codeelementmenge Qx/2 mit den Codeelementen 1 bis 8 und im zweiten Codewort die Codeelementmenge Qx/2 mit den Codeelementen 9 bis 16 untergebracht. Die Wortgröße x/2 ist zum Referenzcodewort RC durch drei Hilfscodeelemente C ergänzt, die hierbei in redundanter Form die Codeart angeben.

Das Codeschema PCM-D(max) nach Fig. 6 kommt mit einem um ein Codeelement geringeren Referenzcodewort RC' aus und spiegelt die dritten der bereits genannten Methoden wieder, bei der überlange PCM-Differenzcodeworte durch PCM-Differenz-Codeworte mit durch die Codeelementmenge Qy darstellbarem maximalen Amplitudenwert, und zwar unter Berücksichtigung der Polarität des hierdurch ersetzten überlangen PCM-Differenzcodewortes, ersetzt werden. In diesem Fall bedarf es keines die Codeart markierenden Hilfscodeelementes C.

Anhand der Fig. 7 bis 12 sollen nun an einem konkreten Beispiel die vier Möglichkeiten der Reduktion des digitalen Signalflusses nach der Erfindung noch näher verdeutlicht werden. Dabei sind diese Figuren mit den Codeschemabezeichnungen entsprechend ihrer Zuordnung zu den Codeschemas nach den Fig. 1 bis 6 versehen.

In der Zeitmatrix nach Fig. 8 sind entsprechend der Anwendung einer Differenzcodemodulation aus den aufeinanderfolgenden PCM-Codeworten S1 bis S12 die PCM-Differenzcodeworte S1/S2, S2/S3 ... S11/S12 gebildet. Wie diese Zeitmatrix zeigt, überschreiten die PCM-Differenzcodeworte S4/S5 und S5/S6 die maximale Wortgröße P + y. Wie Fig. 8 ferner erkennen läßt, sind die Hilfscodeelemente P mit ihrer Wertigkeit dadurch dargestellt, daß vor dem hinter einem Schrägstrich stehenden Symbol P entweder eine « 1 » oder eine « 0 » angegeben ist. Entsprechend sind in den Zeitmatrizen der Fig. 9 bis 11 die die Codeart markierenden Hilfscodeelementen C dargestellt.

In der Zeitmatrix nach Fig. 9 ist angegeben, wie sich die Zeitmatrix nach Fig. 8 ändert, wenn die überlangen PCM-Differenzcodeworte einer Kompandierung unterzogen werden. Zur besseren Übersicht sind neben der Zeitmatrix die aufeinanderfolgenden Referenzcodeworte RC1 bis RC11 als Summe aus der Wortgröße y bzw. y' und der Hilfscodeelemente P und C angegeben.

In der gleichen Weise ist in Fig. 10 die Zeitmatrix für den Fall angegeben, in dem die überlangen PCM-Differenzcodeworte S4/S5 und S5/S6 nach Fig. 8 durch kompandierte PCM-Codeworte ersetzt sind. Weiterhin zeigt Fig. 11 den Fall, bei dem die überlangen PCM-Differenzcodeworte S4/S5 und S5/S6 nach Fig. 8 durch ungekürzte PCM-Codeworte ersetzt sind, die hierbei in zwei aufeinanderfolgenden Codeworten untergebracht sind.

Die Zeitmatrix nach Fig. 12 zeigt schließlich den Fall, bei dem die überlangen PCM-Differenzcodeworte S4/S5 und S5/S6 durch PCM-Differenzcodeworte ersetzt werden, die den maximal darstellbaren Amplitudenwert aufweisen.

Das in Fig. 13 dargestellte Blockschaltbild zeigt die Sende- und Empfangsseite einer Anordnung, die von der Reduktion des digitalen Signalflusses entsprechend den Fig. 3 und 9 Gebrauch macht. Das zu codierende Analogsignal A1 wird dem Codierer CO zugeführt, der aus den Abtastwerten PCM-Codeworte mit einer gleichwertigen Quantisierung bildet. Die PCM-Codeworte werden anschließend dem Differenzbildner DB einmal unmittelbar und zum anderen mal über das Zeitglied T zugeführt, dessen Zeitverzögerung gleich einem PCM-Codewort gewählt ist. Die PCM-Differenzcodeworte am Ausgang des Differenzbildners werden einem Längenvergleicher LV zugeführt, der die PCM-Differenzcodeworte mit einem Referenzcodewort RC fest vorgegebener Länge fortlaufend vergleicht. Solange der Längenvergleicher LV keine Überlänge der PCM-Differenzcodeworte feststellt, werden diese vom Ausgang des Differenzbildners DB über den Umschalter Us und den Addierer AD der Übertragungsleitung Ü zugeführt. Über den zweiten Eingang des Addierers AD wird das die Codierung markierende Hilfscodelement vom Ausgang des Längenvergleichers zugeführt. Bei Feststellen einer Überlänge schaltet der Längenvergleicher LV über seinen Ausgang den Umschalter Us in die andere Schaltstellung, so daß nunmehr dem Addierer AD das PCM-Differenzcodewort in an das Referenzcodewort angepaßter Länge zugeführt wird. Die Kürzung des PCM-Differenzcodewortes erfolgt hierbei in der Kompandiereinrichtung KE.

Auf der Empfangsseite werden in der Empfangseinrichtung E das die Codemarkierung bildende Hilfscodeelement von jedem ankommenden PCM-Differenzcodewort abgetrennt und der Hilfscodeelementerkennung HCE zugeführt, die ihrerseits ausgangsseitig den empfangsseitigen Umschalter Ue steuert. Solange keine Kompandierung vorliegt, werden die PCM-Differenzcodeworte vom Ausgang der Empfangseinrichtung E über den Umschalter Ue dem Codewandler CW zugeführt, der die PCM-Differenzcodeworte in PCM-Codeworte rückwandelt und sie anschließend dem Decodierer DE zuführt, an dessen Ausgang das zurückgewonnene analoge Signal A2 abgenommen werden kann. Bei Erkennen eines kompandierten PCM-Differenzcodewortes schaltet die Hilfscodelementerkennung HCE den Umschalter Ue in seine andere Schaltstellung, in der dem Codewandler CW nunmehr die PCM-Differenzcodeworte vom Ausgang der Empfangseinrichtung E über den Expander EX zugeführt werden. Im Expander EX wird die sendeseitige Kompandierung wieder aufgehoben.

Ein Fig. 13 entsprechendes Blockschaltbild für die Anwendung der Reduktion des digitalen Signalsflusses entsprechend den Fig. 4 und 10 bzw. 5 und 11 zeigt Fig. 14. Die Erzeugung der PCM-Differenzcodeworte sowie ihr Vergleich mit dem Referenzcodewort in einem Längenvergleicher LV erfolgt hier auf die gleiche Weise.

Stellt der Längenvergleicher Lv ein überlanges PCM-Differenzcodewort fest, so werden von seinem Ausgang aus drei Schalter S1, S2 und S3 betätigt, und zwar die Schalter S1 und S2 unmittelbar und Schalter S3 über den Inverter I hinweg. In diesem Falle wird der Schalter S1, der ein Umschalter ist, in die andere Schaltstellung umgelegt, der Schalter S2 geschlossen und der Schalter S3 geöffnet. Dabei wird das für die Differenzbildung gerade zuletzt erzeugte PCM-Codewort vom Ausgang des Codierers CO über die Schaltungsanordnung K/2C dem Addierer AD zugeführt, an dessen zweitem Eingang das die Decodierung kennzeichnende Hilfscodeelement vom Ausgang des Längenvergleichers LV ansteht. Für die Durchführung der Reduktion entsprechend den Fig. 4 und 10 ist die Schaltungsanordnung K/2C eine Kompandiereinrichtung.

Das am Ausgang der Schaltungsanordnung auftretende kompandierte PCM-Codewort wird über den Schalter S1 dem Eingang des Zeitgliedes T zugeführt. Auf diese Weise ist gewährleistet, daß beim Übergang vom kompandierten PCM-Codewort zum PCM-Differenzcodewort dieses PCM-Differenzcodewort aus der Differenz des vorhergehenden kompandierten PCM-Codewortes mit dem zeitlich unmittelbar folgenden PCM-Codewort gebildet wird. Vom Ausgang des Addierers AD werden die Codeworte bei Anwendung kompandierter PCM-Codeworte unmittelbar der Übertragungsstrecke Ü zugeführt.

Empfangsseitig wird von der gleichen Schaltungsanordnung Gebrauch gemacht wie bei Fig. 13. Die Schaltungsanordnung EX/EC ist in diesem Falle ein Expander.

Bei Anwendung der Reduktion des digitalen Signalflusses entsprechend den Fig. 5 und 11 ist die Sendeseite nach Fig. 12 dadurch modifiziert, daß einerseits die Schaltanordnung K/2C nun ein Doppel-Codewortbildner ist und weiterhin dem Addierer AD der in unterbrochener Linie dargestellte Pufferspeicher PS nachgeordnet ist. Weiterhin entfällt hier der Schalter S1, da in diesem Falle der Ausgang des Codierers CO, wie die unterbrochene Linie zeigt, direkt mit dem Eingang des Zeitgliedes T in Verbindung steht. Der Fortfall des Schalters S1 ist in Fig. 12 durch den ihn umgebenden, in unterbrochener Linie gezeichneten Kreis angedeutet. Auf der Empfangsseite ist die Schaltungsanordnung EX/DC ein Doppel-Codewortdecodierer.

Die Schaltungsanordnung nach Fig. 15 zur Durchführung einer Reduktion des digitalen Signalflusses entsprechend den Fig. 6 und 12 unterscheidet sich sendeseitig von der Anordnung nach Fig. 13 lediglich dadurch, daß der Umschalter Us in Abhängigkeit eines im Längenvergleicher LV festgestellten überlangen PCM-Differenzcodewortes den Ausgang der das Referenzcodewort RC speichernden Einrichtung zur Übertragungsleitung Ü hin durchschaltet. Das Referenzcodewort RC ist hier im dafür vorgesehenen Speicher für den hiermit maximal darstellbaren Amplitudenwert gespeichert. Auf der Empfangsseite erfolgt die Rückgewinnung des Analogsignals A2 am Ausgang des Decodierers DE über die Eingangsschaltung E und den Codewandler CW hinweg.

Aus der Sende-Empfangsanordnung nach Fig. 15 wird bei unmittelbarer Verbindung des Ausgangs des Umschalters Us über die in unterbrochener Linie dargestellte Leitung L mit dem Eingang des Codewandlers CW eine Schaltung zur frequenzselektiven Amplitudenbegrenzung eines Analogsignals in Abhängigkeit seiner Amplitudenänderungsgeschwindigkeit. Eine solche Amplitudenbegrenzung ist für die Aufbereitung von Tonprogrammaterial zur Speicherung bzw. zur Übertragung durch Medien erforderlich, deren maximale Übertragungscharakteristik hinsichtlich der Größe der Amplitudenänderungsgeschwindigkeit des Signals frequentabhängig ist.

Beim Aufzeichnen von Tonprogrammen auf Schallplatten oder Magnetbänder ist es üblich, unvermeidbares Rauschen dadurch klein zu halten, daß das zu speichernde oder auch zu übertragende Tonsignal im Bereich seiner höheren Frequenzen angehoben wird (Preemphase). Diese Preemphase hat zur Folge, daß bei hoher Dynamik des Signals im Bereich dieser angehobenen Frequenzanteile, also bei schnellen Amplitudenänderungsgeschwindigkeiten, leicht eine Übersteuerung der Aussteuercharakteristik des Systems auftritt und damit nichtlineare Verzerrungen entstehen, die später nicht mehr vom eigentlichen Signal abgetrennt werden können. Um diese unerwünschten Übersteuerungen zu vermeiden, werden die zu speichernden bzw. zu übertragenden Tonsignale über frequenzabhängig gesteuerte Begrenzerschaltungen, die einen hohen technischen Aufwand bedingen, geleitet. Solche Schaltungen haben aber den Nachteil, daß sie aufgrund ihres verzögerten Einschwingverhaltens auch unerwünschte Begrenzungen von Signalanteilen bewirken. Dieses verzögerte Einschwingverhalten läßt sich zwar dadurch in Grenzen halten, daß ein Mehrfachfrequenzband-Begrenzer vorgesehen wird, dessen Gesamtbandbreite in 1/3 Oktaven-Frequenzbänder aufgeteilt wird und deren Charakteristik je Oktave einzeln programmiert werden kann. Der Aufwand an Filtermitteln ist jedoch erheblich.

Die Durchführung der erforderlichen frequenzselektiven Begrenzung von Tonprogrammen bei ihrer Aufbereitung für Speicher- bzw. Übertragungszwecke in der digitalen Ebene gemäß der Erfindung läßt sich mit bekannten Komponenten der Digitaltechnik in außerordentlich einfacher Weise ohne störende Beeinflussung von unerwünschten Einschwingvorgängen durchführen. Dieser Sachverhalt soll im folgenden anhand des Diagramms der Fig. 16 noch näher erläutert werden.

Bei der Abtastung eines Analogsignals, beispielsweise eines Tonsignals mit einer oberen Grenzfrequenz fo von 16 kHz, im Rhythmus einer Abtastfrequenz fs von 32 kHz, wird ein Signalanteil einer vorgegebenen Frequenz während einer Periode umso öfter abgetastet, je niedriger die Frequenz dieses Signalanteils ist. Die maximal mögliche Amplitudendifferenz zwischen zwei aufeinanderfolgenden Abtastproben eines Tonsignals ist also in erster Näherung der Frequenz des Tonsignals proportional. Die am Ausgang des Differenzwertbildners DB auftretenden PCM-Differenzcodeworte ergeben beim Längenvergleich mit dem Referenzcodewort RC nur dann überlange PCM-Differenzcodeworte, wenn schnelle Amplitudenänderungsgeschwindigkeiten vorliegen, also Amplitudenänderungen im Bereich der hohen Frequenzen des Tonsignals auftreten. Die erforderliche Begrenzung eines solchen überlangen PCM-Differenzcodewortes auf die Codelementzahl des Referenzcodewortes, und zwar in der Weise, daß anstelle des überlangen PCM-Differenzcodewortes der bei der Länge des Referenzcodewortes darstellbare maximale Amplitudenwert in PCM-Differenzcodewort-Darstellung tritt, wirkt sich beim zurückgewonnenen Analogsignal A2 am Ausgang des Decodierers DE nach Fig. 15 in einer Absenkung der Amplituden der Signalanteile im Bereich der höheren Frequenzen entsprechend dem Diagramm nach Fig. 16 aus.

Im Diagramm nach Fig. 16 ist über einer logarithmischen Frequenzskala in den Grenzen von $10^2$ Hz bis $4 \cdot 10^4$ Hz die Pegelabsenkung, ausgehend vom Normalpegel, 0 dB bis − 42 dB aufgetragen, und zwar für die Fälle, in denen die Reduktion des überlangen PCM-Differenzcodewortes um 1, 2, 3, 4 oder 5 Codeelemente CE vorgenommen ist. Diese Codeelementreduzierung ist auf der rechten Seite im Diagramm der Fig. 16 angegeben. Sie stellt gleichsam den Parameter für die Kurven dar, die sich im Diagramm als in Richtung höherer Frequenzen abfallende Geraden darstellen. Danach ergibt sich bei Reduktion um ein Codeelement CE bei einem Tonsignal bei der Eckfrequenz fg des das Tonsignal begrenzenden Tiefpasses noch keine Begrenzung der Amplitude. Da jedes weggelassene Codeelement eine Pegelabsenkung, bezogen auf die Abtastfrequenz fs von 6 dB mit sich bringt, ergibt sich somit bei einer Codeelementreduzierung um zwei Codeelemente CE bei der Eckfrequenz fg eine Reduzierung der Maximalamplitude auf den halben Wert. Amplituden von Tönen, deren Frequenzen gleich oder kleiner als ein Viertel der Abtastfrequenz fs sind, werden davon nicht mehr berührt, weil die maximal auftretenden Amplitudendifferenzwerte in diesem Frequenzbereich bei der hier vorgegebenen Länge des Referenzcodewortes voll darstellbar sind, also einer Länge, die gegenüber einer Referenzcodewortlänge für eine nicht reduzierte Übertragung um zwei Codeelemente gekürzt ist. Wie Fig. 16 zeigt, ergibt sich bei einer Kürzung um fünf Codeelemente CE ein linearer Dämpfungsabfall ab einer Tonfrequenz, die einem Zweiunddreißigstel der Abtastfrequenz fs entspricht.

Da üblicherweise die bei der Aufbereitung von Tonprogrammen vorgenommene Anhebung der Frequenzen im oberen Bereich des Tonsignals pro Oktave mit 6 dB erfolgt, stellt die Schaltung nach Fig. 15 einen idealen Begrenzer dar, dessen abfallende Kennlinien jeweils Bereiche konstanter Amplitudenänderungsgeschwindigkeit bilden. Die senkrecht zu diesen Kennlinien eingezeichnete Mehrfachpfeillinie Pf gibt die stufenweise Änderung der Amplitudenänderungsgeschwindkeit in Richtung abnehmender Werte an.

**Ansprüche**

1. Verfahren zur Codierung von Analogsignalen für Speicher- bzw. Übertragungszwecke, bei dem die abgetasteten Augenblickswerte der Analogsignale in einem Codierer in PCM-Codeworte umgesetzt und anschließend aus jeweils zwei aufeinanderfolgenden PCM-Codeworten durch Differenzbildung PCM-Differenzcodeworte gebildet werden, bei dem ferner jedes der eine Impulsgruppe darstellenden PCM-Differenzcodeworte zusammen mit wenigstens einem weiteren Hilfscodeelement ein Codewort mit fest vorgegebener Länge (Referenzcodewort) bildet, das zur Reduktion des digitalen Signalflusses unter Berücksichtigung der Hilfscodeelemente kürzer gewählt ist als die maximal mögliche Länge eines PCM-Differenzcodewortes, und bei dem bei Auftreten eines eine Überlänge aufweisenden PCM-Differenzcodewortes dieses durch ein Sondercodewort der im Datenformat vorgegebenen Länge ersetzt wird, dadurch gekennzeichnet, daß das Sondercodewort entweder von diesem eine Überlänge aufweisenden PCM-Differenzcodewort durch Wegfall einer der erforderlichen Kürzung entsprechenden Anzahl seiner jeweils niedrigstwertigen Codeelemente gewonnen oder aber durch ein PCM-Codewort gleicher Länge ersetzt wird, das seinerseits aus dem zur Gewinnung dieses überlangen PCM-Differenz-Codewortes zuletzt erzeugten PCM-Codewort gebildet wird.

2. Verfahren nach Anspruch 1, dadurch gekennzeichnet, daß der Erzeugung der PCM-Codeworte und der hieraus abgeleiteten PCM-Differenzcodeworte eine gleichmäßige Quantisierung zugrundegelegt ist.

3. Verfahren nach Anspruch 1 oder 2, dadurch gekennzeichnet, daß das erwähnte, das eine Überlänge aufweisende PCM-Differenzcodewort ersetzende PCM-Codewort von dem zur Gewinnung dieses PCM-Differenzcodewortes zuletzt erzeugten PCM-Codewort durch Weglassen einer entsprechenden Anzahl der jeweils niedrigstwertigen Codeelemente auf die vom Referenzcodewort (RC) vorgegebene übertragbare Länge gekürzt wird (Kompandierung).

4. Verfahren nach Anspruch 3, dadurch gekennzeichnet, daß bei Ersatz eines oder mehrerer überlanger PCM-Differenzcodeworte durch kompandierte PCM-Codeworte beim nachfolgenden Übergang auf PCM-Differenzcodeworte das erste der weiteren PCM-Differenzcodeworte aus der Differenz des letzten kompandierten PCM-Codewortes mit dem zeitlich unmittelbar folgenden PCM-Codewort gebildet wird.

5. Verfahren nach Anspruch 1 oder 2, dadurch gekennzeichnet, daß das erwähnte, das überlange PCM-Differenzcodewort ersetzende PCM-Codewort, das aus dem zur Gewinnung dieses PCM-Differenzcodewortes zuletzt erzeugten PCM-Codewort gebildet wird, bei gleichzeitiger Anwendung einer Zwischenspeicherung auf zwei aufeinanderfolgende Codeworte aufgeteilt wird.

6. Verfahren nach einem der vorhergehenden Ansprüche, dadurch gekennzeichnet, daß von den in jedem Codewort enthaltenen Hilfscodeelementen (C, P) wenigstens eines (C) für die Kennzeichnung der Codierung des eigentlichen Nutzsignals in diesem Codewort vorgesehen ist.

7. Verfahren nach Anspruch 1 oder 2, dadurch gekennzeichnet, daß das erwähnte, das überlange PCM-Differenzcodewort ersetzende PCM-Codewort den größten Augenblicksamplitudenwert beinhaltet, der durch die ihm vorgegebene Codeelementzahl im verwendeten Code darstellbar ist, und zwar unter Berücksichtigung der Polarität des zu ersetzenden überlangen PCM-Differenzcodewortes.

8. Verfahren nach Anspruch 7, gekennzeichnet durch seine Verwendung zur frequenzselektiven Amplitudenbegrenzung eines analogen Signals in Abhängigkeit der Amplitudenanstiegsgeschwindigkeit dadurch, daß die in ihrer Länge vom Referenzcodewert (RC') bestimmten Codeworte einem Codewandler (CW) zur Rückgewinnung der PCM-Codeworte zugeführt werden, aus denen dann anschließend in einem Decodierer (DE) das ursprüngliche Analogsignal (A2) in begrenzter Form erhalten wird.

**Claims**

1. Method for coding analogue signals for storage or transmission purposes, as the case may be, wherein the scanned instantaneous values of the analogue signals are converted into PCM code words in a coder and PCM difference code words are subsequently formed from two consecutive PCM code words by difference formation, and wherein furthermore each of the PCM difference words, which constitutes a pulse group, together with at least one further auxiliary code element forms a code word of a predetermined length (reference code word) which for the reduction of the digital signal flow, is selected, with regard to the auxiliary code elements, to be shorter than the maximal possible length of a PCM difference code word, and wherein on occurrence of a PCM difference code word which has an excess length, the latter is replaced by a special code word of the length prescribed by the data format, characterised in that the special code word is either obtained from the PCM difference code word, which has an excess length, by omitting a number, corresponding to the required shortening, of its respectively lowest value code elements or is replaced by a PCM code word of the same length, which for its part is formed from the last PCM code word produced in order to obtain the excessively long PCM difference code word.

2. Method as claimed in claim 1, characterised in that the production of the PCM code words and the PCM difference code words derived therefrom are based on a uniform quantization.

3. Method as claimed in claim 1 or 2, characterised in that the said PCM code word replacing the PCM difference code word having an excessive length is shortened from the last PCM code word produced in order to obtain the PCM difference code word to the transmittable length prescribed by the reference code word (RC) (companding) by omitting an appropriate number of the respectively lowest-value code elements.

4. Method as claimed in claim 3, characterised in that when replacing one or more excessively long PCM difference code words by companding PCM code words, during the subsequent transition to PCM difference code words, the first of the further PCM difference code words is formed from the difference of the last companded PCM code word and the PCM code word which follows immediately in terms of time.

5. Method as claimed in claim 1 or 2, characterised in that said PCM code word replacing the excessively long PCM difference code word and which is formed from the last PCM code word produced in order to obtain the PCM difference code word, is divided into two consecutive code words while simultaneously applying an intermediate storage.

6. Method as claimed in one the preceding claims, characterised in that at least one (C) of the auxiliary code elements (C, P) which are contained in each code word is provided for the identification of the coding of the actual useful signal in this code word.

7. Method as claimed in claim 1 or 2, characterised in that said PCM code word which replaces the excessively long PCM difference code word, contains the largest instantaneous amplitude value which can be represented by the number of code elements which are specified for said value in the code used and in fact by taking into consideration the polarity of the excessively long PCM difference code word which is to be replaced.

8. Method as claimed in claim 7, characterised by its use for the frequency-selective amplitude limitation of an analogue signal in dependence upon the speed of the amplitude increase in that the code words which are determined in their length by the reference code value (RC') are fed to a code converter (CW) in order to regain the PCM code words, from which the original analogue signal (A2) is subsequently obtained in a decoder (DE) in a limited form.

**Revendications**

1. Procédé de codage de signaux analogiques dans des buts de mémorisation ou de transmission, dans lequel les valeurs instantanées échantillonnées des signaux analogiques sont convertis en mots de code PCM dans un codeur, et des mots de code différentiels PCM sont ensuite formés par formation de la différence entre deux mots de code PCM respectifs successifs, dans lequel en outre chacun des mots de code différentiels représentant un groupe d'impulsions forme, en association avec au moins un autre élément de code auxiliaire, un mot de code de longueur prédéterminée de façon fixe (mot de code de référence) qui, pour la réduction du débit de signaux numériques en tenant compte des éléments de code auxiliaires, est choisi plus court que la longueur possible au maximum d'un mot de code différentiel PCM, et dans lequel, à l'apparition d'un mot de code différentiel PCM trop long, celui-ci est remplacé par un mode de code spécial de la longueur prédéterminée dans le format de données, caractérisé par le fait que le mot de code spécial est obtenu à partir de ce mot de code différentiel PCM trop long, par suppression d'un nombre, correspondant au raccourcissement nécessaire, de ses éléments de code respectifs de poids minimal ou bien est remplacé par un mot de code PCM de même longueur qui, de son côté, est formé à partir du mot de code PCM produit en dernier pour obtenir ce mot de code différentiel PCM trop long.

2. Procédé suivant la revendication 1, caractérisé par le fait que la production des mots de code PCM et des mots de code différentiels PCM qui en sont dérivés a pour base une quantification uniforme.

3. Procédé suivant la revendication 1 ou 2, caractérisé par le fait que le mot de code PCM mentionné, remplaçant le mot de code différentiel PCM trop long, est raccourci à la longueur pouvant être transmise prédéterminée par le mot de code de référence (RC), à partir du mot de code PCM produit en dernier pour obtenir ce mot de code différentiel PCM, par suppression d'un nombre correspondant des éléments de code de poids respectivement minimum (compression-expansion).

4. Procédé suivant la revendication 3, caractérisé par le fait que lors du remplacement d'un ou de plusieurs mots de code différentiels PCM trop longs par des mots de code PCM soumis à une compression-expansion, lors du passage ultérieur à des mots de code différentiels PCM, le premier des autres mots de code différentiels PCM est formé à partir de la différence du dernier mot de code PCM soumis à une compression-expansion et du mot de code PCM qui le suit immédiatement dans le temps.

5. Procédé suivant la revendication 1 ou 2, caractérisé par le fait que le mot de code PCM mentionné qui remplace le mot de code différentiel PCM trop long et qui est formé à partir du mot de code PCM produit en dernier pour l'obtention de ce mot de code différentiel PCM, est subdivisé en deux mots de code successifs avec utilisation simultanée d'une mémorisation intermédiaire.

6. Procédé suivant l'une des revendications précédentes, caractérisé par le fait que parmi les éléments de code auxiliaires (C, P) contenus dans chaque mot de code, au moins un (C) est prévu pour la caractérisation du codage du signal utile proprement dit dans ce mot de code.

7. Procédé suivant la revendication 1 ou 2, caractérisé par le fait que le mot de code PCM mentionné remplaçant le mot de code différentiel PCM trop long contient la valeur d'amplitude instantanée maximale qui peut être représentée par le nombre d'éléments de code prédéterminé pour celle-ci dans le code utilisé, et ce en tenant compte de la polarité du mot de code différentiel PCM trop long devant être remplacé.

8. Procédé suivant la revendication 7, caractérisé par son utilisation pour la limitation d'amplitude sélective en fréquence d'un signal analogique en fonction de la vitesse de croissance de l'amplitude du fait que les mots de code déterminés en longueur par la valeur du code de référence (RC') sont appliqués à un convertisseur de code (CW) pour la régénération des mots de code PCM à partir desquels le signal analogique initial (A2) est alors obtenu ensuite sous forme limitée, dans un décodeur (DE).

FIG 1

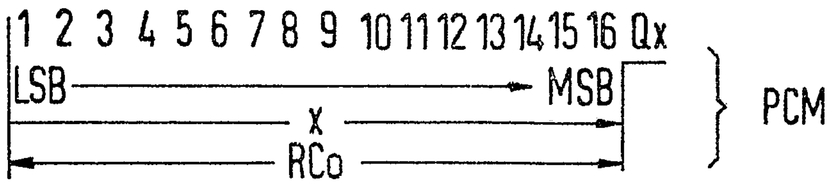


FIG 2

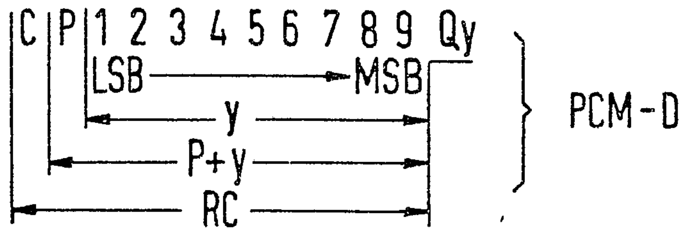


FIG 3

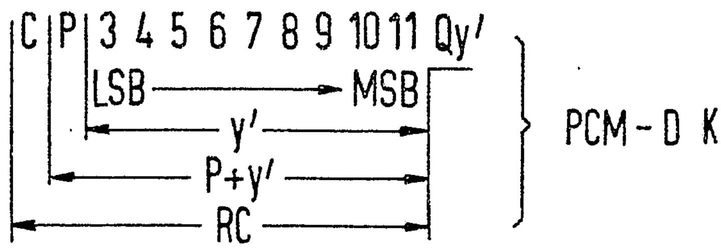


FIG 4

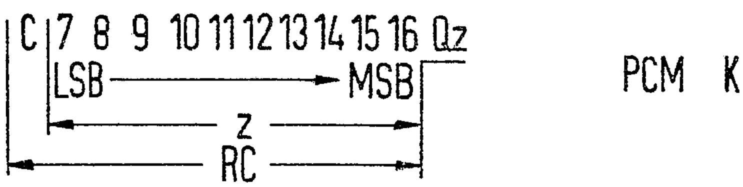


FIG 5

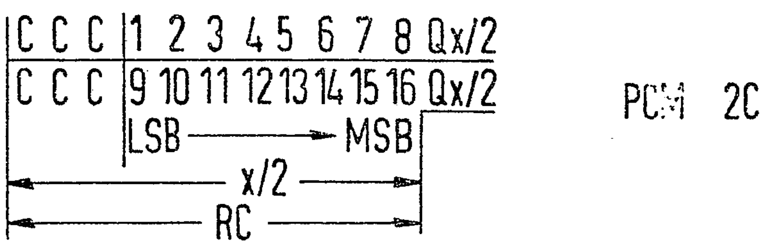


FIG 6

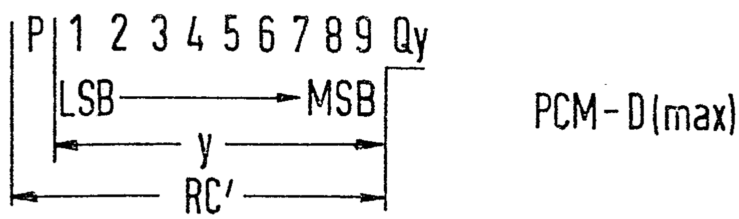

FIG 7

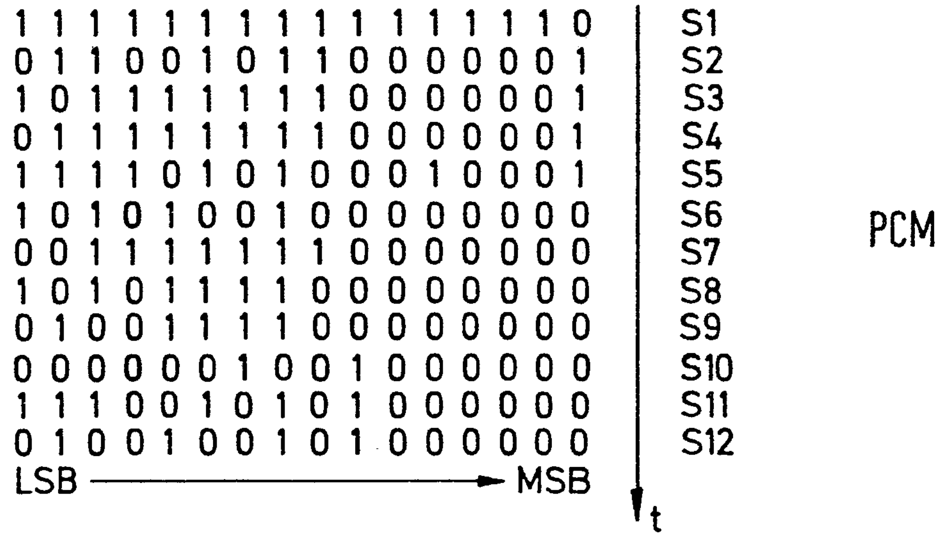


FIG 8

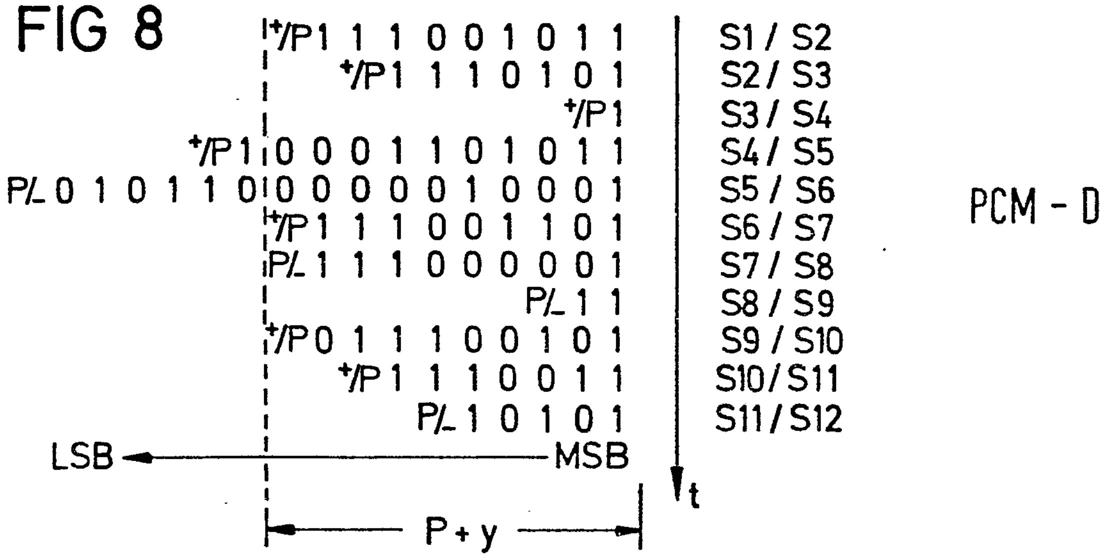


FIG 9

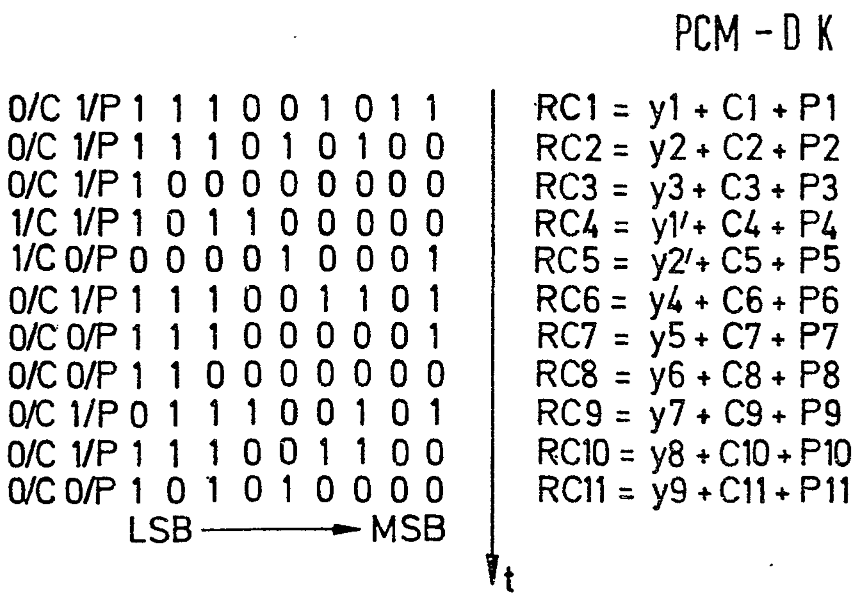

FIG10

| Bits | Equation |
|---|---|
| 1/C 1 1 1 1 1 1 1 1 1 0 | RC1 = z1 + C1 |
| 0/C 1/P0 1 1 0 0 1 1 1 1 | RC2 = y1 + P1 + C2 |
| 0/C 1/P1 1 1 0 1 0 1 0 0 | RC3 = y2 + P2 + C3 |
| 0/C 1/P1 0 0 0 0 0 0 0 0 | RC4 = y3 + P3 + C4 |
| 1/C 0 1 0 0 0 1 0 0 0 1 | RC5 = z2 + C5 |
| 1/C 0 1 0 0 0 0 0 0 0 0 | RC6 = z3 + C6 |
| 0/C 1/P0 0 1 1 1 1 1 0 1 | RC7 = y4 + C7 + P4 |
| 0/C 0/P1 1 1 0 0 0 0 0 1 | RC8 = y5 + C8 + P5 |
| 0/C 0/P1 1 0 0 0 0 0 0 0 | RC9 = y6 + C9 + P6 |
| 0/C 1/P0 1 1 1 0 0 1 0 1 | RC10 = y7 + C10 + P7 |
| 0/C 1/P1 1 1 0 0 1 1 0 0 | RC11 = y8 + C11 + P8 |
| 0/C 0/P1 0 1 0 1 0 0 0 0 | RC12 = y9 + C12 + P9 |
| LSB ← MSB | |

PCM K

FIG11

| Bits | Equation | |
|---|---|---|
| 1/C0/C0/C1 1 1 1 1 1 1 0 | RC1 = $x/2_{1a}$ + C1-3 | } - S1 |
| 1/C1/C1/C1 1 1 1 1 1 1 1 | RC2 = $x/2_{1b}$ + C4-6 | |
| 0/C1/P 1 1 1 0 0 1 0 1 1 | RC3 = y1 + C7 + P1 | |
| 0/C1/P 1 1 1 0 1 0 1 0 0 | RC4 = y2 + C8 + P2 | |
| 0/C1/P 1 0 0 0 0 0 0 0 0 | RC5 = y3 + C9 + P3 | |
| 1/C0/C0/C 0 0 0 1 0 0 0 1 | RC6 = $x/2_{2a}$ + C10-C12 | } - S5 |
| 1/C1/C1/C1 1 1 1 0 1 0 1 | RC7 = $x/2_{2b}$ + C13-C15 | |
| 1/C0/C0/C 0 0 0 0 0 0 0 0 | RC8 = $x/2_{3a}$ + C16-C18 | } - S6 |
| 1/C1/C1/C 1 0 1 0 1 0 0 1 | RC9 = $x/2_{3b}$ + C19-C21 | |
| 0/C1/P 1 1 1 0 0 1 1 0 1 | RC10 = y4 + C22 + P4 | |
| 0/C0/P 1 1 1 0 0 0 0 0 1 | RC11 = y5 + C23 + P5 | |
| 0/C0/P 1 1 0 0 0 0 0 0 0 | RC12 = y6 + C24 + P6 | |
| 0/C1/P 0 1 1 1 0 0 1 0 1 | RC13 = y7 + C25 + P6 | |
| 0/C1/P 1 1 1 0 0 1 1 0 0 | RC14 = y8 + C27 + P7 | |
| 0/C0/P 1 0 1 0 1 0 0 0 0 | RC15 = y9 + C28 + P8 | |
| LSB ← MSB | t | |

PCM 2C

FIG12

| Bits | Equation |
|---|---|
| 1/P1 1 1 0 0 1 0 1 1 | RC'1 = y1 + P1 |
| 1/P1 1 1 0 1 0 1 0 0 | RC'2 = y2 + P2 |
| 1/P1 0 0 0 0 0 0 0 0 | RC'3 = y3 + P3 |
| 1/P1 1 1 1 1 1 1 1 1 | RC'4 = $y_{max}$ + P4 |
| 0/P1 1 1 1 1 1 1 1 1 | RC'5 = $y_{max}$ + P5 |
| 1/P1 1 1 0 0 1 1 0 0 | RC'6 = y4 + P6 |
| 0/P1 1 1 0 0 0 0 0 1 | RC'7 = y5 + P7 |
| 0/P1 1 0 0 0 0 0 0 0 | RC'8 = y6 + P8 |
| 1/P0 1 1 1 0 0 1 0 1 | RC'9 = y7 + P9 |
| 1/P1 1 1 0 0 1 1 0 0 | RC'10 = y8 + P10 |
| 0/P1 0 1 0 1 0 0 0 0 | RC'11 = y9 + P11 |
| LSB → MSB | t |

PCM-$D_{max}$

FIG 13

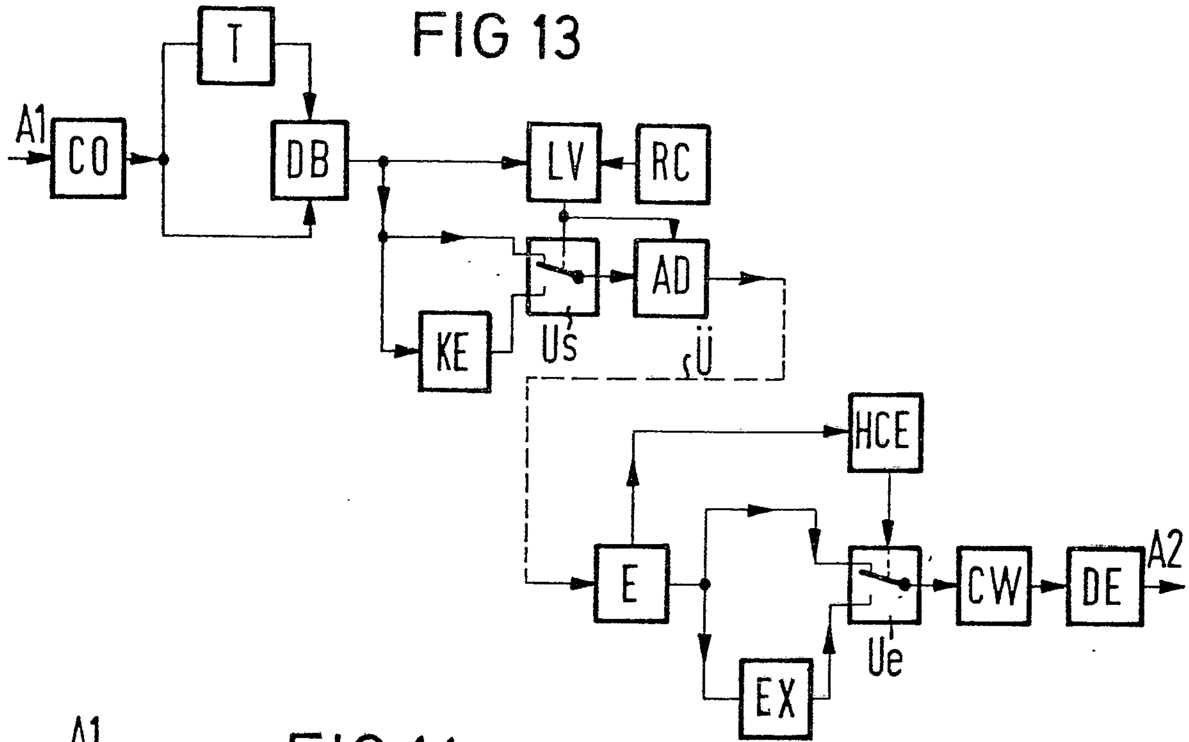
A1
CO
T
DB
LV
RC
KE
Us
AD
Ü
HCE
E
EX
Ue
CW
DE
A2

FIG 14

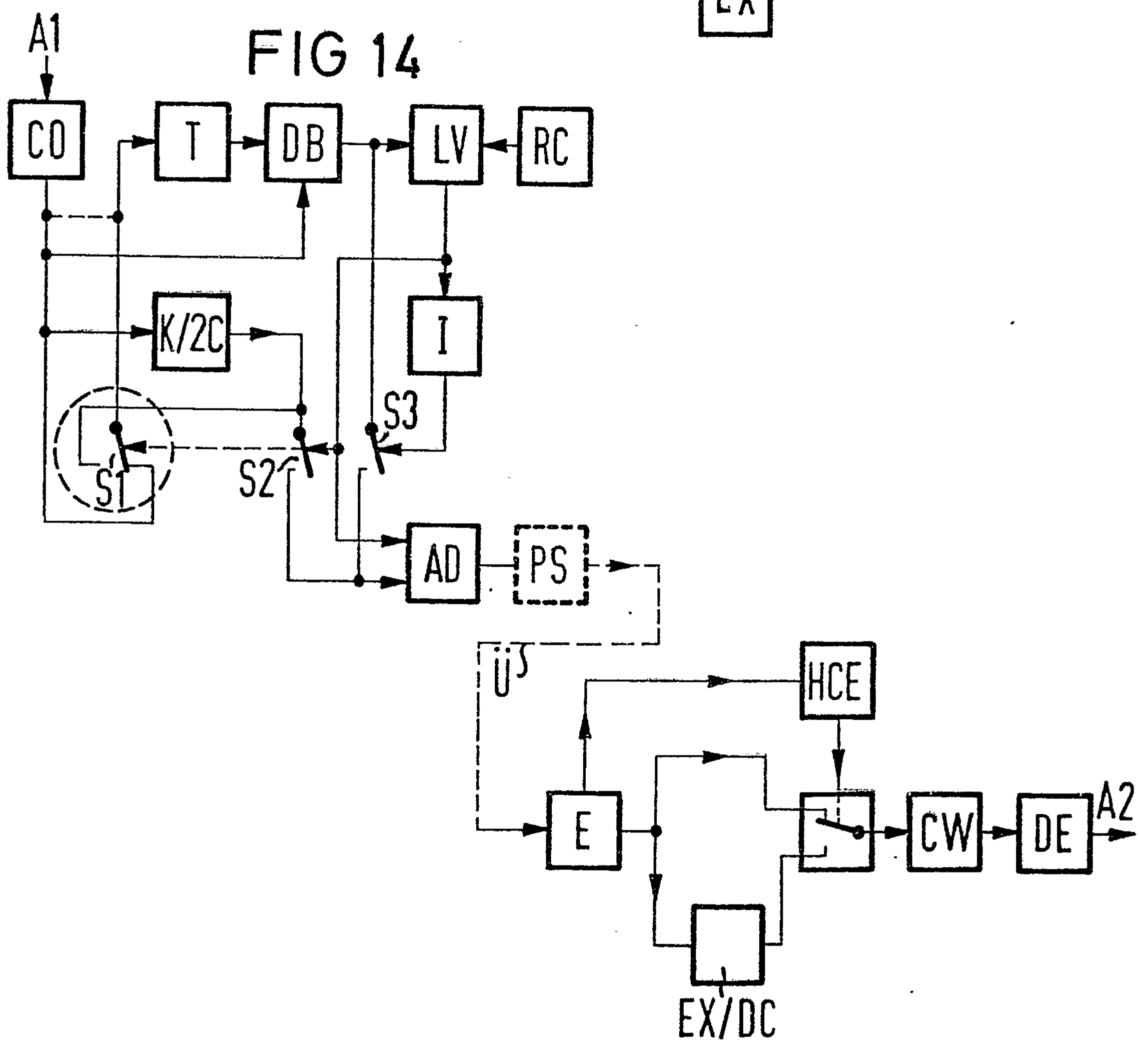
A1
CO
T
DB
LV
RC
K/2C
I
S1
S2
S3
AD
PS
Ü
HCE
E
EX/DC
CW
DE
A2

FIG 15

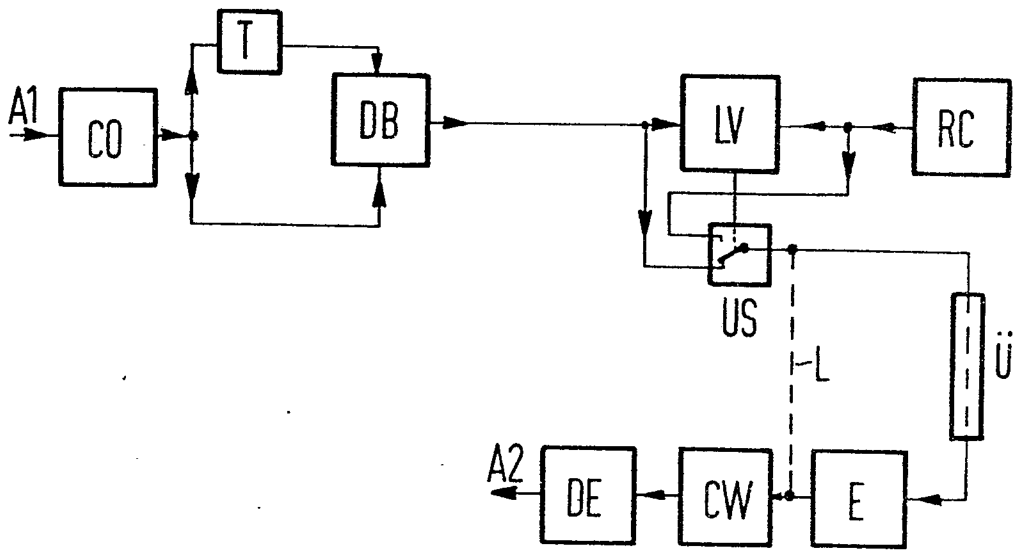
A1
CO
T
DB
LV
RC
US
L
Ü
A2
DE
CW
E

FIG 16

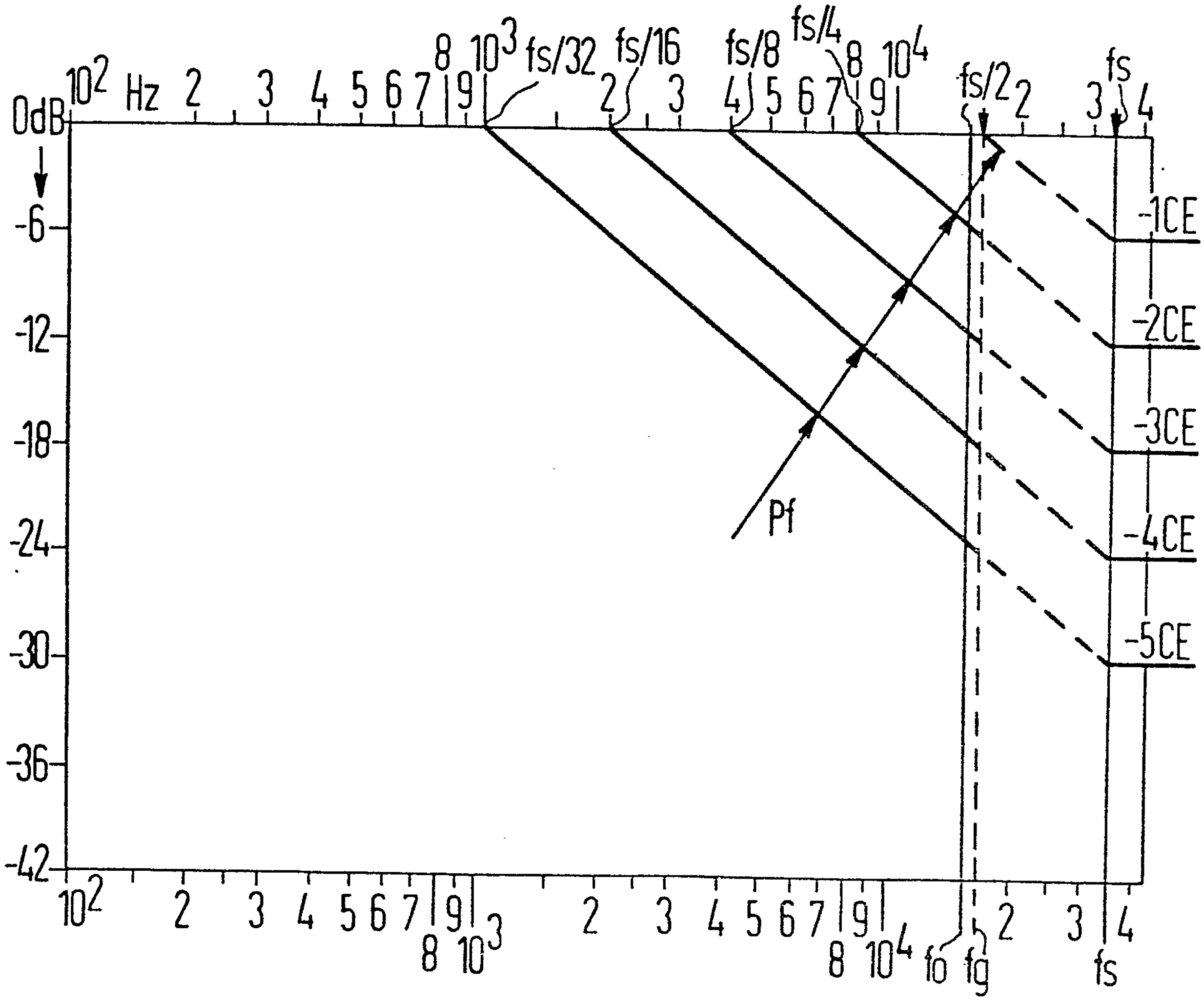
0dB
-6
-12
-18
-24
-30
-36
-42
Hz
fs/32
fs/16
fs/8
fs/4
fs/2
fs
Pf
-1CE
-2CE
-3CE
-4CE
-5CE
fo
fg